# EUROPEAN PATENT APPLICATION

(11) **EP 2 672 729 A1**
(43) Date of publication of application: **11.12.2013**
(21) Application number: 13170803.4
(22) Date of filing: 06.06.2013
(51) Int. Cl.: H04R 5/02

(54) **Audio output apparatus and method for outputting audio**

(30) Priority: 08.06.2012 KR 20120061589
(71) Applicant: Samsung Electronics Co., Ltd, Gyeonggi-do 443-742 (KR)
(72) Inventor: Lee, Jae-cheol, Gyeonggi-do (KR); Kim, Byung-soo, Seoul (KR); Shim, Jae-seong, Gyeonggi-do (KR); Cho, Kee-yeong, Seoul (KR)
(74) Representative: Davies, Robert Ean

(57) **Abstract**

An audio output apparatus and a method for outputting audio are provided. The audio output apparatus includes a receiver which receives a multi-channel audio signal that includes channels; an amplifier which amplifies the received multi-channel audio signal for each channel; and an audio output which includes speakers that output the channels of the amplified multi-channel audio signal, respectively.

## Description

### CROSS-REFERENCE TO RELATED APPLICATIONS

This application claims priority from Korean Patent Application No. 2012-0061589, filed in the Korean Intellectual Property Office on June 8, 2012, the disclosure of which is herein incorporated by reference.

### BACKGROUND

### 1. Field

Apparatuses, devices, and methods consistent with the present disclosure relate to an audio output apparatus and a method for outputting audio, and more particularly, to an audio output apparatus which may receive a plurality of multi-channel audio signals simultaneously and output them individually, and a method for outputting audio thereof.

### 2. Description of the Related Art

In the related art technology, if multi-channel audio signals are input to an audio system, a single-channel audio signal is amplified using an amplifier, transmitted to a speaker, and then output as audio. The channel signals constituting the multi-channel audio signals should be connected to the same number of speakers and thus, as the number of channels increases, so does the number of the speakers.

For example, in order to reproduce a multi-channel signal of 7.1 ch, eight individual speakers are required. In the related art technology, even if an audio system is configured to use bi-amping, or an audio system is configured to use a channel divider, a single audio input signal should be processed and output to a single speaker and thus, multiple channels may not be output to a single speaker simultaneously.

In order to realize an audio system to output multi-channel audio signals using the related art speaker, the number of speakers should be increased as many as the number of channels.

As the number of speakers increase, an audio output system takes up a large space, and an additional speakers are required to output multi-channel sound.

### SUMMARY

It is an aspect to provide an audio output apparatus capable of outputting multi-channel audio signals which have been input individually and a method for outputting audio.

According to an aspect of an exemplary embodiment, there is provided an audio output apparatus including a receiver which receives multi-channel audio signal that includes a plurality of channels; an amplifier which amplifies the received multi-channel audio signal for each channel; and an audio output which includes a plurality of speakers that output the channels of the amplified multi-channel audio signal, respectively.

The plurality of speakers may be disposed spaced part by a predetermined distance.

The receiver may include a plurality of receiving terminals which receive the channels of the multi-channel audio signal.

The apparatus may further include a volume controller which increases or decreases a volume of the channels.

The apparatus may further include an input interface which receives a plurality of audio signals from a plurality of sound sources.

The apparatus may further include a switch which switches at least one audio signal from among the plurality of input audio signals to the input.

The apparatus may further include a signal processor which performs signal-processing with respect to the switched audio signal.

According to an aspect of an exemplary embodiment, there is provided a method for outputting audio, the method including inputting a multi-channel audio signal that includes a plurality of channels; amplifying the input multi-channel audio signal for each channel; and outputting the amplified audio signals, respectively.

The outputting may include outputting the amplified multi-channel audio signal for each channel to a plurality of speakers, which are spaced apart from each other by a predetermine distance.

The inputting may include comprises separately inputting channels of the multi-channel audio signal.

The outputting may include increasing or decreasing a volume of each channel.

The outputting may further include receiving a plurality of audio signals from a plurality of sound sources.

The outputting may further include switching at least one audio signal from among the plurality of input audio signals to the input.

The outputting may further include performing signal-processing with respect to a switched audio signal after the switching operation.

### BRIEF DESCRIPTION OF THE DRAWINGS

The above and/or other aspects will be more apparent by describing certain exemplary embodiments with reference to the accompanying drawings, in which:

FIG. 1 is a block diagram to explain a configuration of an audio output apparatus according to an exemplary embodiment;

FIG. 2 is a block diagram to explain a configuration of an audio output apparatus which is capable of outputting two audio signals in detail according to an exemplary embodiment;

FIG. 3 is a view to explain a structure of the audio output apparatus illustrated in FIG. 2 in detail;

FIG. 4 is a view to explain a front side of an audio output apparatus which is capable of outputting three audio signals according to another exemplary embodiment;

FIG. 5 is a concept view to explain a plurality of audio output apparatuses which is applicable to a home theater system with a 5.1 channel audio system according to an exemplary embodiment;

FIG. 6 is a block diagram to explain an audio processing apparatus which is connected to an audio output apparatus according to an exemplary embodiment;

FIG. 7 is a view to explain the block diagram illustrated in FIG. 6 in greater detail;

FIG. 8 is a flowchart to explain a method for outputting audio according to another exemplary embodiment; and

FIG. 9 is a flowchart to explain a method for outputting audio according to another exemplary embodiment in greater detail.

### DETAILED DESCRIPTION

Certain exemplary embodiments are described in higher detail below with reference to the accompanying drawings.

In the following description, like drawing reference numerals are used for the like elements, even in different drawings. The matters defined in the description, such as detailed construction and elements, are provided to assist in a comprehensive understanding of exemplary embodiments. However, exemplary embodiments can be practiced without those specifically defined matters. Also, well-known functions or constructions are not described in detail since they would obscure the application with unnecessary detail.

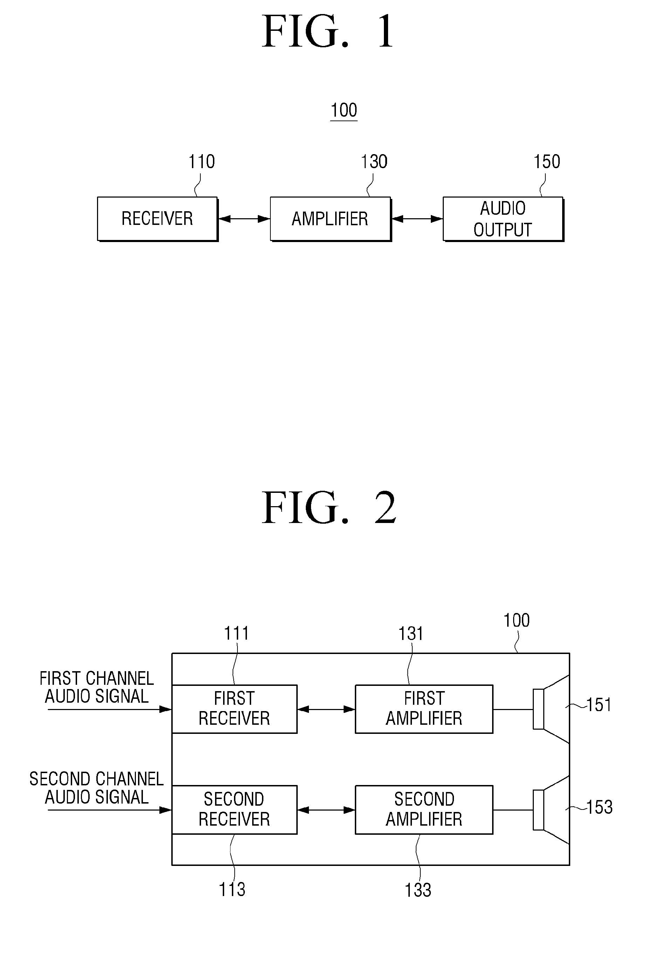

FIG. 1 is a block diagram to explain configuration of an audio output apparatus according to an exemplary embodiment.

Referring to FIG. 1, an audio output apparatus 100 according to an exemplary embodiment comprises a receiver 110, an amplifier 130, and an audio output 150.

The receiver 110 receives multi-channel audio signals. That is, the receiver 110 may be configured as a plurality of receiving terminals to receive audio signals by channel. The audio signals received through a plurality of receiving terminals are different from each other and input to the amplifier 130 channel by channel.

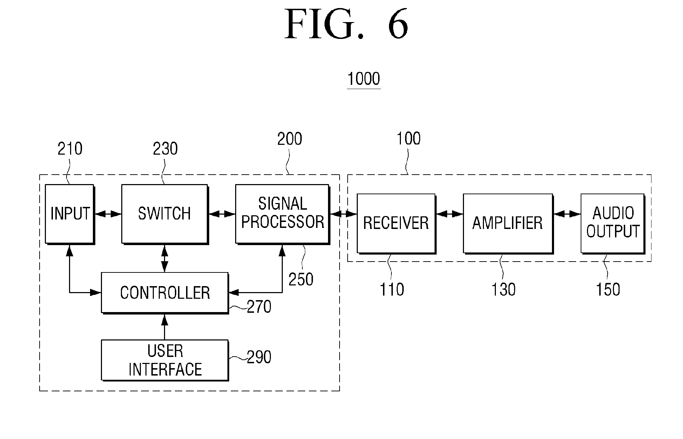

The receiver 110 may be realized as a receiving terminal in various forms. The receiver 110 is capable of receiving an audio signal from the audio processing apparatus 200 via cable (see FIG. 6). (However, alternatively a wireless connection may be used.) For example, the receiver 110 may be realized in various types such as plug type, socket type, direct cable connection type, and so on.

The amplifier 130 amplifies or reduces a size of a waveform of an audio signal which is input from the receiver 110 channel by channel to a predetermined size. The amplifier 130 comprises of a plurality of amplifiers. That is, the amplifier 130 has one amplifier for each channel, and one amplifier is connected to one speaker. The amplifier 130 according to an exemplary embodiment comprises amplifiers as many as the number of channels supported by the audio output apparatus 100. In other words, the number of audio signals which can be processed by the audio output apparatus 100 is determined by the number of amplifiers of the amplifier 130.

The audio output 150 outputs an audio signal that is amplified by the amplifier 130 channel by channel. The audio output 150 comprises a plurality of speakers which are connected to amplifiers of the amplifier 130 one by one. The audio output 150 outputs multi-channel audio simultaneously through a plurality of speakers channel by channel.

Specifically, the audio output 150 comprises a plurality of speakers, and each of the speakers outputs a single-channel audio signal respectively. In this case, each speaker is separated from each other physically, and an audio signal of a different channel is input to each speaker, and thus each speaker outputs an audio signal of a different channel simultaneously, outputting multi-channel mono sound.

According to an exemplary embodiment, an audio signal of the same channel may be input to each speaker. In this case, each speaker outputs stereo sound as each speaker outputs an audio signal of the same channel simultaneously. For example, if there are more than three speakers, the first speaker may output mono sound of the first channel, and the second and third speakers may output stereo sound of the second channel.

FIG. 2 is a block diagram to explain a configuration of an audio output apparatus which is capable of outputting two channel audio signals in detail according to an exemplary embodiment.

Referring to FIG. 2, the audio output apparatus capable of two channel audio signals comprises a plurality of receivers 111, 113, a plurality of amplifiers 131, 133, and a plurality of speakers 151, 153.

In FIG. 2, the audio output apparatus 100 comprises a plurality of receivers 111, 113 to receive two channel audio signals, respectively. The plurality of receivers 111, 113 comprises a first receiver 111 and a second receiver 113. In order to receive more than three audio signals, a plurality of receivers may comprise more than three receivers.

The first receiver 111 receives the first channel audio signal, and the second receiver 113 receives the second channel audio signal. In this case, the first audio signal and the second audio signal may be different sound sources or the same sound source.

If the first audio signal and the second audio signal are different sound sources, the first audio signal and the second audio signal may include different contents of audio signals. If they are the same sound source, the first audio signal and the second audio signal may include the same contents and stereo sound may be realized using the first audio signal and the second audio signal.

The plurality of amplifiers 131, 133 comprises a first amplifier 131 and a second amplifier 133. The first amplifier 131 is connected to the first receiver 111 to receive the first channel audio signal and amplifies the received first channel audio signal. The second amplifier 133 is connected to the second receiver 113 to receive the second channel audio signal and amplifies the received second channel audio signal.

The audio output apparatus 100 according to an exemplary embodiment receives audio signals channel by channel through a plurality of receiving terminals, respectively, and amplifies the received audio signals channel by channel.

The amplified first channel audio signal and the amplified second channel audio signal are output through a plurality of speakers 151, 153, respectively.

The plurality of speakers 151, 153 are spaced apart by a predetermined distance, and receive and output audio signals of different channels, respectively. The plurality of speakers 151, 153 are included in a housing unit (not shown) and may be configured in an integrated form.

However, the plurality of speakers 151, 153 output audio signals amplified by the first amplifier 131 and the second amplifier 133 respectively and thus, the plurality of speakers 151, 153 do not interfere with each other physically. That is, the plurality of speakers 151, 153 may output the first channel audio signal and the second channel audio signal simultaneously. For example, the audio output 150 with two speakers may output audio signals of two channels simultaneously, and the number of audio signal channels which may be output simultaneously increase as many as the number of speakers increases.

In another exemplary embodiment, as illustrated in FIG. 2, the audio output apparatus 100 with two speakers receives two audio signals through the plurality of receivers 111, 113, and outputs two channel mono sound respectively through the plurality of outputs 151, 153 if the received two audio signals are different channels from each other. However, if the received two audio signals are the same channel, single-channel stereo sound is output through the plurality of outputs 151, 153.

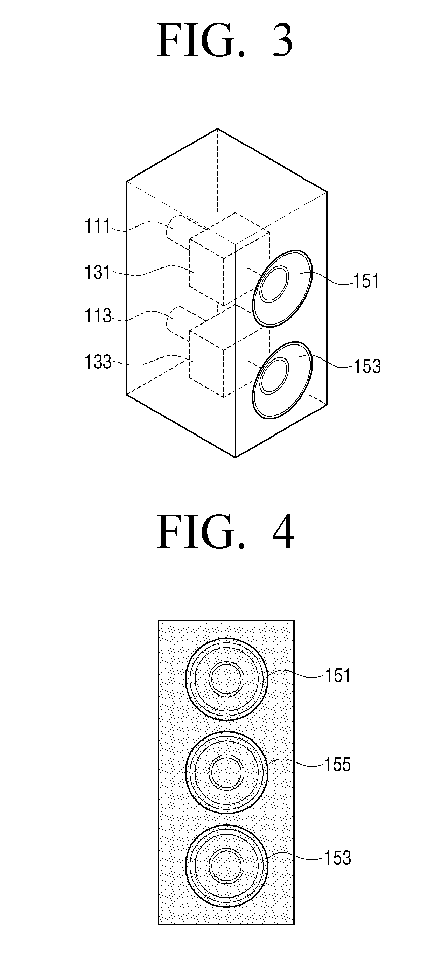

FIG. 3 is a view to explain a structure of the audio output apparatus illustrated in FIG. 2 in detail.

Referring to FIG. 3, the front side of the audio output 100 comprises two speakers 151, 153. The two speakers 151, 153 have the same directivity, and are spaced apart from each other by a predetermined distance. The audio output apparatus 100 comprises the plurality of receivers 111, 113, and a plurality of amplifiers 131, 133.

It can be seen that the plurality of receivers 111, 113 illustrated in FIG. 3 are located on the opposite side of the plurality of speakers 151, 153. Alternatively, the plurality of receivers 111, 113 may be configured in various forms on a side which is different from the opposite side to where the plurality of speakers 151, 153 are formed.

FIG. 4 is a view to explain a front side of an audio output apparatus which is capable of outputting three channel audio signals according to another exemplary embodiment.

Referring to FIG. 4, the audio output apparatus 100 includes three speakers to output three channel audio signals. The audio output apparatus 100 may thus comprise three speakers 151, 153 and 155, and the three speakers 151, 153 and 155 may be spaced apart from each other. In FIG. 4, the three speakers 151, 153 and 155 are configured as the same speaker having the same output capacity, but the three speakers 151, 153 and 155 may be configured to have different output capacity from each other.

For example, the first and the second speakers 151, 153 may output audio to realize stereo sound, and the third speaker 155 may output medium and low sound so that the audio output apparatus 100 may produce surround sound.

In another exemplary embodiment, the three speakers 151, 153 and 155 may output audio signals of different channels from each other. For example, the first speaker 151 outputs an audio signal of the first channel, the second speaker 153 outputs an audio signal of the second channel, and the third speaker 155 outputs an audio signal of the third channel. If an audio signal of each channel is different from each other, the sound output by the audio output apparatus 100 is a sound in which different audio signals are mixed.

FIG. 4 illustrates three speakers as an example, but more than three speakers may be provided in another exemplary embodiment.

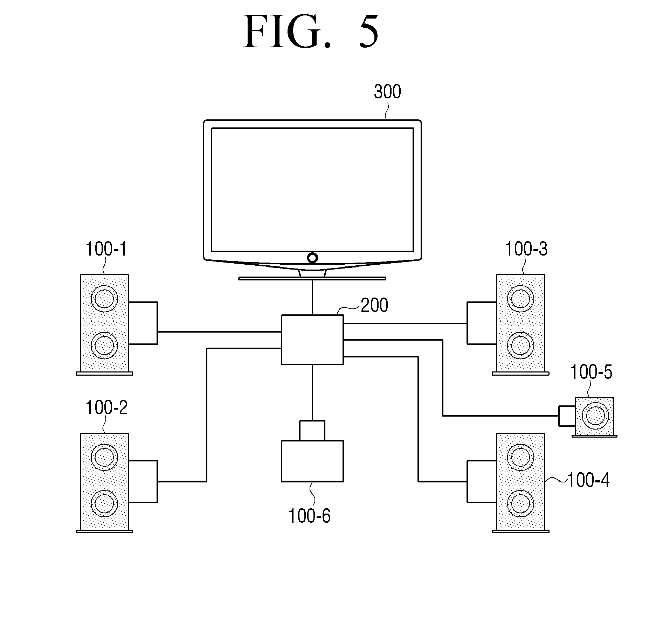

FIG. 5 is a concept view to explain a plurality of audio output apparatuses which are applicable to a home theater system with a 5.1 channel audio system according to an exemplary embodiment.

Referring to FIG. 5, six audio output apparatuses 100-1 to 100-6 are used to realize a home theater system with a 5.1 channel audio system. The first audio output apparatus 100-1 is a front left output, the second audio output apparatus 100-2 is a rear left output, the third audio output apparatus 100-3 is a front right output, the fourth audio output apparatus 100-4 is a rear right output, the fifth audio output 100-5 is a sub woofer, and the sixth audio output 100-6 is a center output.

The plurality of audio output apparatuses 100-1 to 100-6 are connected to the audio processing apparatus 200 via cable. However, alternatively a wireless connection may be used. In FIG. 5, the audio processing apparatus 200 is separated from an audio output apparatus, but the audio processing apparatus 200 may be formed integrally with an audio output apparatus. For example, the center output 100-6 and the audio processing apparatus 200 may be realized as an integrated apparatus.

The plurality of audio output apparatuses 100-1 to 100-6 are realized as stereo speakers and thus, may output two channel audio signals, respectively. As illustrated in FIG. 5, the plurality of audio output apparatuses 100-1 to 100-6 may be connected to each other via two cables, respectively, from the audio processing apparatus 200. Alternatively, wireless connection may be used.

One or more of the audio output apparatuses 100-1 to 100-6 may operate as an audio output apparatus capable of outputting two channels, respectively. For example, if the first audio output apparatus 100-1 and the third audio output apparatus 100-3 operate as two channel audio output apparatuses, the six audio output apparatuses illustrated in FIG. 5 may operate as if eight audio output apparatuses are connected. Accordingly, if the first audio output apparatus 100-1 and the third audio output apparatus 100-3 operate as two channel audio output apparatuses, an audio output system may output an audio signal as 7.1 channel. However, the two audio output apparatuses 100-1 and 100-3 output two channel mono sound.

An audio output system which is realized by the audio output apparatus 100 according to an exemplary embodiment may output audio of desired channels without increasing the number of audio output apparatuses as many as the number of desired channels.

FIG. 6 is a block diagram to explain an audio processing apparatus which is connected to an audio output apparatus according to an exemplary embodiment.

Referring to FIG. 6, an audio output system 1000 according to an exemplary embodiment comprises the audio output apparatus 100 and the audio processing apparatus 200.

The audio output apparatus 100 comprises the receiver 100, the amplifier 130 and the audio output 150. Since the audio output apparatus has already been explained in detail, further description will be omitted.

In FIG. 6, the audio output apparatus 100 and the audio processing apparatus 200 are separated from each other, but the audio output apparatus 100 and the audio processing apparatus 200 may be realized as a single integrated apparatus. That is, the audio output apparatus 100 may be configured to further include the input 210. However, the audio processing apparatus 200 may be configured separately as below.

The audio processing apparatus 200 comprises an input 210, a switch 230, and a signal processor 250.

The input 210 receives audio data from outside. That is, the input 210 receives a plurality of audio signals from a plurality of sound sources. In this case, the plurality of sound sources represent audio signal supply apparatuses in various forms. For example, the plurality of sound sources represent apparatuses capable of providing audio signals in various forms, such as a DVD player, a CD player, a Blu-ray player, a radio, an MP3 player or a storing medium including media files, and so on.

The switch 230 switches at least one audio signal from among a plurality of audio signals input through the input 210 and transmits the audio signal to the signal processor 250. The switch 230 selects an audio signal to be signal-processed from among a plurality of audio signals and transmits the selected audio signal to the signal processor 250. The switch 230 may switch a specific audio signal from among a plurality of audio signals in accordance with a control command from a user.

The signal processor 250 converts the audio signal which is switched by the switch 230 into a digital signal by performing digital signal-processing. That is, the signal processor 250 performs comprehensive signal processing such as changing a format of an audio signal according to a user's control signal, changing a sound codec to comply with a reception interface of the audio output apparatus 100, etc., in order to convert an audio signal into a digital signal.

The controller 270 controls the input 210, the switch 230 and the signal processor 250 according to a control command from a user, in order to perform signal-processing with respect to at least on audio signal from among a plurality of audio signals.

The user interface 290 inputs a control command from a user. The user interface 290 may be realized as a plurality of buttons, a touch pad, a remote controller, and so on. If the user interface 290 is realized as a wireless remote controller, the audio processing apparatus 200 may comprise a wireless receiver so that a user may input a control command using a separate wireless remote controller. The above method of user interface is known and thus, further description will be omitted.

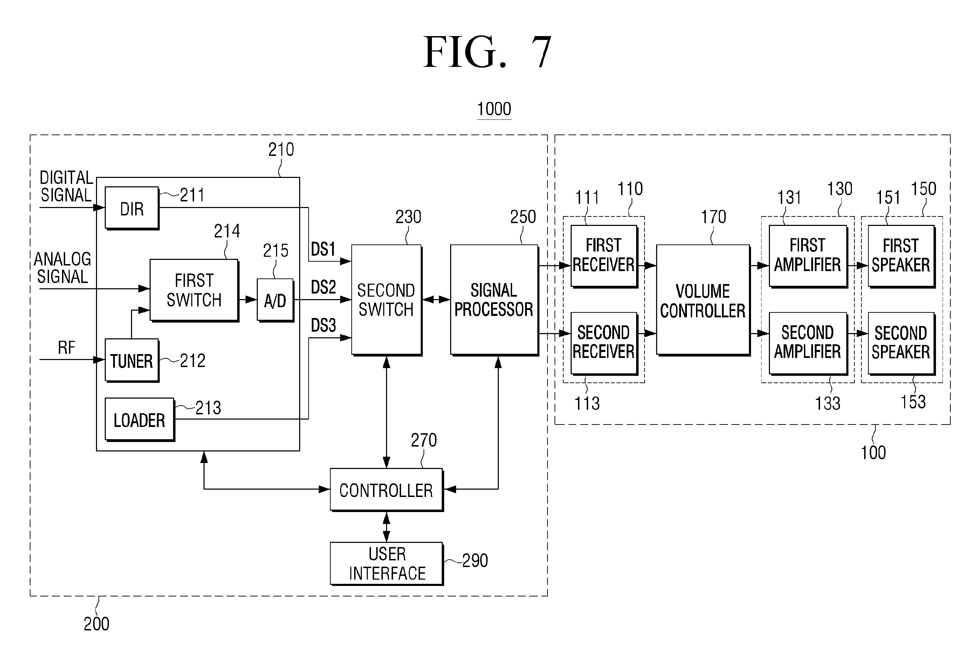

FIG. 7 is a view to explain the block diagram illustrated in FIG. 6 in greater detail. Referring to FIG. 7, the audio output apparatus and the audio processing apparatus according to an exemplary embodiment may be realized as a single integrated apparatus.

The audio output system 1000 may comprise the audio output apparatus 100 and the audio processing apparatus 200.

Since the configuration of the audio output apparatus 100 and the audio processing apparatus 200 has been explained above, the overall operations of the audio output system 1000 will be explained with reference to FIG. 7.

The input 210 comprises a plurality of inputs to receive various audio signals. That is, the input 210 may receive various audio signals included in a digital signal, an analog signal and a Radio Frequency (RF) signal. In the case of a digital signal, the digital signal is converted into a 12S signal through a DIR 211. In the case of an analog signal, the analog signal is converted into a digital signal through an A/D converter 215 by being switched by a first switch 214. An RF signal is received through a tuner 212 and is converted into a digital signal by the A/D converter 215 through the first switch 214. The input 210 stores a digital audio signal in itself or is connected to a medium storing a digital audio signal separately and thus, the input 210 may read out a digital audio signal from a loader 213 which is a medium storing the digital audio signal.

A second switch 230 selects one of the first digital signal (DS1), the second digital signal (DS2), and the third digital signal (DS3), and performs a switching operation to transmit the selected digital signal to the signal processor 250.

The signal processor 250 performs signal-processing to change the format or size of the digital signal switched by the second switch 250 to comply with the audio output apparatus 100. The signal processor 250 performs signal-processing with respect to the switched audio signal to be in the format which complies with the operation specification of the audio output apparatus 100. In this case, the signal processor 250 performs signal processing with respect to the switched audio signal for each channel. If the audio signal switched by the second switch 230 is an audio signal read out from the loader 213 and this signal is a 7.1 channel audio signal, the signal processor 250 performs signal-processing with respect to the audio signal individually for each channel (the first channel to the seventh channel).

In FIG. 7, an audio output apparatus 100 having two receivers is illustrated, but this is only an example. The receiver may be realized as a plurality of receiving terminals. The receiver 110 having two receivers includes the first receiver 111 and the second receiver 113, as shown in FIG. 7.

The volume of the audio signal received by each of the first receiver 111 and the second receiver 113 is adjusted by a volume controller 170 so as to increase or decrease the volume by adjusting the waveform scale of the audio signal.

The audio signal of which volume is adjusted is input the amplifier 130. The first audio signal of which volume is adjusted is input to a first amplifier 131, and the second audio signal of which volume is adjusted is input to a second amplifier 133. The first and second audio signals input to the amplifiers 131 and 133 are amplified, respectively.

The first and second audio signals which are amplified are output through the first and second speakers 151 and 153, respectively.

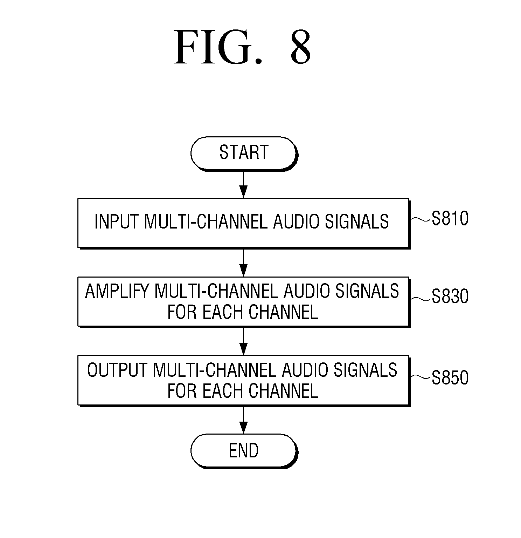

FIG. 8 is a flowchart to explain a method for outputting audio according to another exemplary embodiment.

Referring to FIG. 8, an audio outputting method according to another exemplary embodiment comprises receiving multi-channel audio signals (S810), amplifying the received multi-channel audio signals (S830), and outputting the amplified multi-channel audio signals, respectively (S850).

The operation of receiving multi-channel audio signals comprises receiving each audio signal through a receiving terminal of the audio output apparatus 100. That is, multi-channel audio signals are received through a plurality of receiving terminals. Specifically, a single-channel audio signal constituting multi-channel audio signals is received through each of the receiving terminals for each channel (S810).

The operation of amplifying audio signals comprises amplifying the audio signals received through each of a plurality of receiving terminals for each channel. That is, the operation of amplifying audio signals increases or decreases an amplitude of a digital audio signal to a scale which can be output in reality (S830).

The operation of outputting audio signals comprises outputting the audio signals which are amplified for each channel, respectively. That is, the amplified audio signals are output through a plurality of speakers for each channel. In this case, a plurality of speakers are spaced apart by a predetermined distance and thus, the amplified multi-channel audio signals are output through an individual channel for each channel (S850).

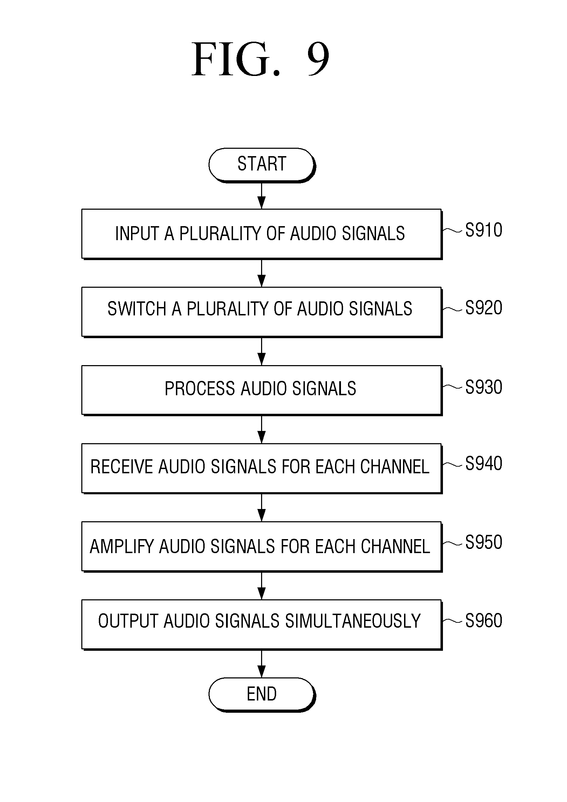

FIG. 9 is a flowchart to explain a method for outputting audio according to another exemplary embodiment in greater detail.

Referring to FIG. 9, a more specific method for outputting audio according to another exemplary embodiment comprises inputting a plurality of audio signals (S910), switching a plurality of audio signals (S920), processing the audio signals (S930) by performing signal-processing with respect to the audio signals, receiving audio signals for each channel (S940), amplifying audios signals for each channel (S950), and outputting audio signals simultaneously (S960).

The audio outputting method illustrated in FIG. 9 further comprises an operation which is performed prior to the operation of receiving multi-channel audio signals (s810) in the flowchart of FIG. 8.

That is, the operation of inputting a plurality of audio signals comprises receiving a plurality of audio signals from a plurality of sound sources. A plurality of audio signals in various forms are received from a CD player, a DVD player, a Blu-ray player, radio, an MP3 player, a cassette player, a radio, a digital audio signal storing medium, and so on (S910).

The operation of switching a plurality of audio signals comprises switching at least one of a plurality of the input audio signals. That is, after receiving a plurality of audio signals from various sound sources, an audio signal from among a plurality of audio signals is switched in order to perform signal-processing with respect to the audio signal selected by a user (S920).

After the switching operation (S920), the operation of performing signal-processing with respect to audio signals comprises performing signal-processing with respect to the switched audio signals to be in a form which can be output in an audio output apparatus. That is, in order to output the switched audio signals in an audio output apparatus, the frequency, amplitude, and form of the audio signals are signal-processed (S930).

Since the method after the operation of receiving the signal-processed audio signals for each channel (S940) is the same as the audio output method described above with reference to FIG. 8, further description will be omitted.

The method illustrated in FIGS. 8 and 9 may be performed not only in the audio output apparatus illustrated in FIG. 1 but also in an audio output apparatus and a sound device having other configuration.

The audio output apparatus according to various exemplary embodiments may receive multi-channel audio signals and output the input multi-channel audio signals simultaneously for each channel and thus, has the effect of processing and outputting a single-channel stereo sound and multi-channel mono sound simultaneously.

Although a few embodiments have been shown and described, it will be appreciated by those skilled in the art that changes may be made in these exemplary embodiments without departing from the principles and spirit of the disclosure, the scope of which is defined in the claims and their equivalents.

## Claims

1. An audio output apparatus, comprising:
a receiver which receives multi-channel audio signals;
an amplifier which amplifies the received multi-channel audio signals for each channel; and
an audio output which includes a plurality of speakers outputting the amplified multi-channel audio signals, respectively.

2. The apparatus as claimed in claim 1, wherein the plurality of speakers are disposed spaced part by a predetermined distance.

3. The apparatus as claimed in claim 1, wherein the receiver includes a plurality of receiving terminals which receive the multi-channel audio signals for each channel.

4. The apparatus as claimed in claim 1, further comprising:
a volume controller which increases or decreases a volume of the plurality of audio signals for each channel.

5. The apparatus as claimed in claim 1, further comprising:
an input interface which receives a plurality of audio signals from a plurality of sound sources.

6. The apparatus as claimed in claim 5, further comprising:
a switch which switches at least one audio signal from among the plurality of input audio signals.

7. The apparatus as claimed in claim 6, further comprising:
a signal processor which performs signal-processing with respect to the switched audio signal.

8. A method for outputting audio, comprising:
inputting multi-channel audio signals;
amplifying the input multi-channel audio signals for each channel; and
outputting the amplified audio signals, respectively.

9. The method as claimed in claim 8, wherein the outputting comprises outputting the amplified multi-channel audio signals for each channel, which are spaced apart from each other by a predetermine distance.

10. The method as claimed in claim 8, wherein the inputting comprises inputting the multi-channel audio signals for each channel.

11. The method as claimed in claim 8, wherein the outputting comprises increasing or decreasing a volume of the plurality of audio signals for each channel.

12. The method as claimed in claim 8, wherein the outputting further comprises:
receiving a plurality of audio signals from a plurality of sound sources.

13. The method as claimed in claim 12, wherein the outputting further comprises:
switching at least one audio signal from among the plurality of input audio signals.

14. The method as claimed in claim 13, wherein the outputting further comprises:
performing signal-processing with respect to a switched audio signal after the switching step.
